# EUROPÄISCHE PATENTSCHRIFT

(11) **EP 0 587 931 B1**
(45) Veröffentlichungstag und Bekanntmachung des Hinweises auf die Patenterteilung: **26.06.1996**
(21) Anmeldenummer: 92115841.6
(22) Anmeldetag: 16.09.1992
(51) Int. Cl.: H03K 19/003

(54) **CMOS-Pufferschaltung**
CMOS buffer circuit
Circuit tampon CMOS

(43) Veröffentlichungstag der Anmeldung: 23.03.1994
(73) Patentinhaber: SIEMENS AKTIENGESELLSCHAFT, D-80333 München (DE)
(72) Erfinder: Murphy, Brian, B. Sc., W-8345 Brombach (DE)

(56) Entgegenhaltungen:
- US-A- 4 039 869
- US-A- 5 057 715
- IEEE JOURNAL OF SOLID-STATE CIRCUITS Bd. 23, Nr. 3, Juni 1988, NEW YORK (US) Seiten 816 - 819 PRIBYL ET AL 'cmos output buffer for megabit dram's'

## Beschreibung

Die Erfindung betrifft eine CMOS-Pufferschaltung mit einem p-Kanal-MOS-Transistor, dessen Source-Anschluß mit der Betriebsspannungsquelle und dessen Substrat-Anschluß mit einer Pump-Spannungsquelle verbunden ist und mit einem dazu in Serie geschalteten ersten n-Kanal MOS-Transistor, dessen Source-Anschluß mit dem Bezugspotential und dessen Drain-Anschluß mit dem Ausgangsanschluß verbunden ist.

Wie beispielsweise der Schrift "CMOS Output Buffers for Megabit DRAM's" aus IEEE Journal of Solid-State Circuits, Volume 23, No. 3, Juni 1988 zu entnehmen ist, besteht ein großes Problem solcher CMOS-Schaltungen darin, daß sie eine große Empfindlichkeit bezüglich des sogenannten Latch-Up-Phänomens aufweisen.

Dabei kann ein parasitärer Thyristor gezündet werden, wenn die Spannung am Ausgangsanschluß größer als die Summe aus der Betriebsspannung und der Basis-Emitter-Spannung eines Transistors oder kleiner als die Differenz aus Bezugspotential und der Basis-Emitter-Spannung eines Transistors wird.

Da ein Zünden dieses parsitären Thyristors zur Zerstörung des Chips, auf dem sich die CMOS-Schaltung befindet, führen würde, müssen geeignete Maßnahmen zur Verhinderung eines Latch-Up getroffen werden.

Es ist üblich, den Substratanschluß des -Kanal-MOS-Transistors an eine Spannung zu legen, die kleiner oder gleich dem Bezugspotential ist und den Substratanschluß des p-Kanal-MOS-Transistors an eine Spannung zu legen, die größer als die Betriebsspannung ist. Im normalen Betriebsfall kann damit das Auftreten eines Latch-Up verhindert werden.

Da die beiden Substratspannungen jedoch von der Betriebsspannung abgeleitet werden und durch sogenannte Pump-Schaltungen erzeugt werden, dauert es eine gewisse Zeit, bis diese Spannungen ihren Endwert nach dem Einschalten der Betriebsspannung erreicht haben. Während dieser Zeit ist das Zünden des parasitären Thyristors nach wie vor möglich, wenn am Ausgangsanschluß einer CMOS-Pufferschaltung ein entsprechender Pegel anliegt.

Die Druckschrift US-A 5 057 715 zeigt eine CMOS-Pufferschaltung mit einem p-Kanal MOSFET, dessen Source-Anschluß mit der Betriebsspannungsquelle verbunden ist und mit einem dazu in Serie geschalteten ersten n-Kanal MOSFET, dessen Source-Anschluß mit dem Bezugspotential und dessen Drain-Anschluß mit dem Ausgangsanschluß verbunden ist, wobei ein zweiter, als "zero-threshold" ausgeführter, n-Kanal MOSFET zwischen den p-Kanal MOSFET und den ersten n-Kanal MOSFET in Serie mit diesen geschaltet ist, und wobei der Gate-Anschluß des zweiten n-Kanal MOSFETs mit der Betriebsspannungsquelle verbunden ist.

Das Ziel der Erfindung ist es somit, das Auftreten eines Latch-Up auch zwischen dem Einschalten der Betriebsspannung und dem Einsetzen der Wirkung der Pumpspannungen zu verhindern, ohne einen Komplisierten und aufwendig zu realisierenden "zero-threshold" - MOSFET verwenden zu müssen.

Dazu ist bei einer gattungsgemäßen CMOS-Pufferschaltung ein zweiter n-Kanal-MOS-Transistor zwischen den p-Kanal-MOS-Transistor und den ersten n-Kanal-MOS-Transistor in Serie mit diesen geschaltet, wobei dessen Gate-Anschluß mit der Pump-Spannungsquelle verbunden ist.

Dieser zweite n-Kanal-MOS-Transistor verhindert, daß eine am Ausgangsanschluß anliegende Spannung zum p-Kanal-MOS-Transistor durchgeschaltet wird, bevor die Pump-Spannung ihren Nennwert erreicht hat. Ein Latch-Up wird somit zuverlässig verhindert.

In vorteilhafter Ausgestaltung der erfindungsgemäßen CMOS-Pufferschaltung ist zwischen dem Source-Anschluß und dem Substrat-Anschluß des p-Kanal-MOS-Transistors eine in Durchlaßrichtung gepolte erste Diode mit geringer Schwellspannung geschaltet.

Diese Diode verhindert einerseits, daß ein mit der Betriebsspannung verbundener parasitärer Transistor, dessen Basis-Emitter-Diode parallel zu der erfindungsgemäßen Diode mit geringer Schwellspannung liegt, durchschaltet, andererseits wird über diese Diode die Kapazität der Wanne, in der der p-Kanal-MOS-Transistor integriert ist, auf nahezu Betriebsspannung aufgeladen, so daß die Pump-Spannungsquelle, die sonst die Wannenkapazität aufladen müßte, weniger belastet wird und somit schneller ihre Nennspannung erreicht.

In weiterer vorteilhafter Weiterbildung der Erfindung ist zwischen die Pump-Spannungsquelle und den Substratanschluß des p-Kanal-MOS-Transistors eine in Durchlaßrichtung gepolte zweite Diode geschaltet. Diese zweite Diode entkoppelt die Pump-Spannungsquelle von der Wanne, wodurch geringere Forderungen an die Eigenschaften der ersten Diode gestellt werden können.

Um die Gate-Kapazität des zweiten n-Kanal-MOS-Transistors von der Wannenkapazität zu entkoppeln, wird in vorteilhafter Weise außerdem zwischen den Substrat-Anschluß des p-Kanal-MOS-Transistors und den Gate-Anschluß des zweiten n-Kanal-MOS-Transistors eine in Durchlaßrichtung gepolte dritte Diode geschaltet. Diese dritte Diode verringert zudem in vorteilhafter Weise den Gate-Oxid-Stress.

Die drei Dioden sind zweckmäßigerweise mittels n-Kanal-MOS-Transistoren gebildet.

Die Erfindung wird nachfolgend anhand von Ausführungsbeispielen mit Hilfe von Figuren näher erläutert. Es zeigen dabei
- Figur 1: eine erste Ausführungsform einer erfindungsgemäßen CMOS-Pufferschaltung und
- Figur 2: eine zweite, vorteilhafte erweiterte Ausführungsform einer erfindungsgemäßen CMOS-Pufferschaltung.

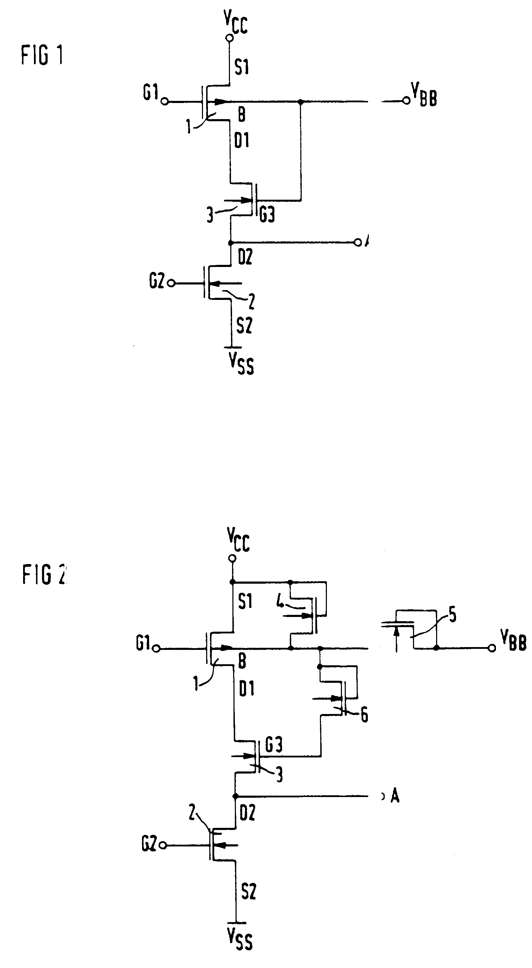

Figur 1 zeigt eine CMOS-Pufferschaltung mit einem p-Kanal-MOS-Transistor 1, dessen Source-Anschluß S1 mit einer Betriebsspannungsquelle V_{CC} verbunden ist. In Serie zu diesem PMOS-Transistor 1 ist ein erster n-Kanal-MOS-Transistor 2 geschaltet, dessen Source-Anschluß S2 mit dem Bezugspotential V_{SS} und dessen Drain-Anschluß D2 mit dem Ausgangsanschluß A verbunden ist. Zwischen dem PMOS-Transistor 1 und dem NMOS-Transistor 2 ist in Serie zu diesen ein zweiter n-Kanal-MOS-Transistor 3 angeordnet. Sein Gate-Anschluß G3 ist ebenso wie der Substrat-Anschluß B des PMOS-Transistors 1 mit einer Pump-Spannungsquelle V_{BB} verbunden. Die beiden Gate-Anschlüsse G1, G2 des PMOS-Transistors 1 und des ersten NMOS-Transistors 2 sind isoliert dargestellt. Sie können aber auch miteinander verbunden sein, wodurch ein CMOS-Inverter gebildet würde.

Der zweite NMOS-Transistor 3 verbindet den Ausgangsanschluß A mit dem Drain-Anschluß D1 des PMOS-Transistors 1 erst, wenn die Pump-Spannungsquelle V_{BB} die von der Betriebsspannung V_{CC} gespeist wird, ihren Endwert erreicht hat. Auf diese Weise kann ein zu hohes oder zu niedriges Potential am Ausgangsanschluß A nicht zum Zünden eines parasitären Thyristors, der aufgrund der in Figur 1 dargestellten CMOS-Schaltung im Substrat entsteht, führen.

In Figur 2 ist eine erfindungsgemäße Weiterbildung der in Figur 1 dargestellten CMOS-Pufferschaltung dargestellt. So ist hier zusätzlich der Source-Anschluß S1 des PMOS-Transistors 1 mit dem Substrat-Anschluß B über eine mittels eines NMOS-Transistors gebildete erste Diode 4 verbunden. Diese Diode 4 sorgt dafür, daß die Wanne, in der der PMOS-Transistor 1 im Substrat, auf dem die gesamte Schaltung integriert ist, gebildet ist, durch die Betriebsspannungsquelle V_{CC} aufgeladen wird, so daß die Pump-Spannungsquelle V_{BB} schneller zum Einsatz kommt. Außerdem verhindert diese erste Diode 4 ein Durchschalten eines parasitären bipolaren Transistors, da ihre Schwellspannung geringer ist als die Basis-Emitter-Spannung dieses parasitären Transistors.

Da die Pump-Spannungsquelle V_{BB} meist weit weg von der Pufferschaltung auf dem Substrat gebildet ist, und somit über eine lange Leitung mit dem Substrat-Anschluß B verbunden ist, verhindert eine, ebenfalls mittels eines n-MOS-Transistors gebildete zweite Diode 5, die nahe am Substrat-Anschluß B angeordnet ist, daß die Kapazität dieser Leitung von der Betriebsspannungsquelle V_{CC} geladen werden muß.

Um die Kapazität der Wanne von der Gate-Kapazität des Gates G3 des zweiten NMOS-Transistors 3 zu entkoppeln, ist eine dritte Diode 6, die auch mittels eines NMOS-Transistors gebildet ist, zwischen dem Substrat-Anschluß B des PMOS-Transistors 1 und dem Gate-Anschluß G3 des zweiten NMOS-Transistors 3 angeordnet.

## Patentansprüche

1. CMOS-Pufferschaltung
mit einem p-Kanal-MOS-Transistor (1), dessen Source-Anschluß (S1) mit der Betriebsspannungsquelle (V_{CC}) und dessen Substratanschluß (B) mit einer Pump-Spannungsquelle (V_{BB}) verbunden ist und
mit einem dazu in Serie geschalteten ersten n-Kanal-MOS-Transistor (2), dessen Source-Anschluß (S2) mit dem Bezugspotential (V_{SS}) und dessen Drain-Anschluß (D2) mit dem Ausgangsanschluß (A) verbunden ist,
**dadurch gekennzeichnet**,
daß ein zweiter n-Kanal-MOS-Transistor (3) zwischen den p-Kanal-MOS-Transistor (1) und den ersten n-Kanal-MOS-Transistor (2) in Serie mit diesen geschaltet ist, und daß dessen Gate-Anschluß (G3) mit der Pump-Spannungsquelle (V_{BB}) verbunden ist.

2. CMOS-Pufferschaltung nach Anspruch 1, bei der zwischen dem Source-Anschluß (S1) und dem Substrat-Anschluß (B) des p-Kanal-MOS-Transistors (1) eine in Durchlaßrichtung gepolte erste Diode (4) mit geringer Schwellspannung geschaltet ist.

3. CMOS-Pufferschaltung nach Anspruch 2, bei der zwischen die Pump-Spannungsquelle (V_{BB}) und den Substrat-Anschluß (B) des p-Kanal-MOS-Transistors (1) eine in Durchlaßrichtung gepolte zweite Diode (5) geschaltet ist.

4. CMOS-Pufferschaltung nach einem der Ansprüche 2 oder 3, bei der zwischen den Substrat-Anschluß (B) des p-Kanal-MOS-Transistors (1) und den Gate-Anschluß (G3) des zweiten n-Kanal-MOS-Transistors (3) eine in Durchlaßrichtung gepolte dritte Diode (6) geschaltet ist.

5. CMOS-Pufferschaltung nach einem der Ansprüche 2 bis 4, bei der die Dioden (4, 5, 6) mittels n-Kanal-MOS-Transistoren gebildet sind.

## Claims

1. CMOS buffer circuit,
having a p-channel MOS transistor (1), the source terminal (S1) of which transistor (1) is connected to the operating voltage source (V_{CC}) and the substrate terminal (B) of which transistor (1) is connected to a pump voltage source (V_{BB}), and
having a first n-channel MOS transistor (2) connected in series with the said p-channel MOS transistor (1), the source terminal (52) of which transistor (2) is connected to the reference potential (V_{SS}) and the drain terminal (D2) of which transistor (2) is connected to the output terminal (A),
characterized
in that a second n-channel MOS transistor (3) is connected between the p-channel MOS transistor (1) and the first n-channel MOS transistor (2), in series with these transistors (1) and (2), and
in that the gate terminal (G3) of the said second n-channel MOS transistor (3) is connected to the pump voltage source (V_{BB}).

2. CMOS buffer circuit according to Claim 1, in which a first diode (4), which is forward biased and has a low threshold voltage, is connected between the source terminal (S1) and the substrate terminal (B) of the p-channel MOS transistor (1).

3. CMOS buffer circuit according to Claim 2, in which a second diode (5), which is forward biased, is connected between the pump voltage source (V_{BB}) and the substrate terminal (B) of the p-channel MOS transistor (1).

4. CMOS buffer circuit according to either of Claims 2 and 3, in which a third diode (6), which is forward biased, is connected between the substrate terminal (B) of the p-channel MOS transistor (1) and the gate terminal (G3) of the second n-channel MOS transistor (3).

5. CMOS buffer circuit according to one of Claims 2 to 4, in which the diodes (4, 5, 6) are formed by means of n-channel MOS transistors.

## Revendications

1. Circuit tampon CMOS
comportant un transistor (1) MOS à canal p, dont la borne (S1) de source est reliée à la source (V_{CC}) de tension de fonctionnement et dont la borne (B) le substrat est reliée à une source (V_{BB}) de tension de pompage et
un premier transistor (2) MOS à canal n, qui est branché en série avec le transistor (1), dont la borne (S2) de source est reliée au potentiel (V_{SS}) de référence et dont la borne (D2) de drain est reliée à la borne (A) de sortie,
caractérisé en ce que
un second transistor (3) MOS à canal n est branché entre le transistor (1) MOS à canal p et le premier transistor (2) MOS à canal n en série avec ceux-ci, et la borne (G3) de grille de ce second transistor (3) est reliée à la source (V_{BB}) de tension de pompage.

2. Circuit tampon CMOS suivant la revendication 1, dans lequel une première diode (4) polarisée dans le sens passant et à tension de seuil petite est branchée entre la borne (S1) de source et la borne (B) de substrat du transistor (1) MOS à canal p.

3. Circuit tampon CMOS suivant la revendication 2, dans lequel une seconde diode (5) polarisée dans le sens passant est branchée entre la source (V_{BB}) de tension de pompage et la borne (B) de substrat du transistor (1) MOS à canal p.

4. Circuit tampon CMOS suivant l'une des revendications 2 ou 3, dans lequel une troisième diode (6) polarisée dans le sens passant est branchée entre la borne (B) de substrat du transistor (1) MOS à canal p et la borne (G3) de grille du second transistor (3) MOS à canal n.

5. Circuit tampon CMOS suivant l'une des revendications 2 à 4, dans lequel les diodes (4,5,6) sont formées de transistors MOS à canal n.
